# DEMANDE DE BREVET EUROPEEN

(11) **EP 1 052 529 A1**
(43) Date de publication de la demande: **15.11.2000**
(21) Numéro de dépôt: 00401255.5
(22) Date de dépôt: 09.05.2000
(51) Int. Cl.: G02B 6/12, C30B 25/02

(54) **Structure dielectrique périodique du type à bande interdite photonique tridimensionnelle et son procédé de fabrication**

(30) Priorité: 11.05.1999 FR 9906013
(71) Demandeur: AGENCE SPATIALE EUROPEENNE, F-75738 Paris Cedex 15 (FR)
(72) Inventeur: De Maagt, Peter, 2316 AP Leiden (NL); Gonzalo, Ramon, 26005 Logrono, La Rioja (ES); Crone, Gerald, 2161 En Lisse (NL)
(74) Mandataire: Thibon-Littaye, Annick

(57) **Abrégé**

L'invention concerne une structure cristalline (5), du type dit à bande interdite photonique tridimensionnelle, ainsi que son procédé de fabrication. Elle comprend un empilement constitué de deux séries de couches alternées (30, 31) en des matériaux distincts associés à des première et deuxième constantes diélectriques, qui forment un bloc (3) sensiblement parallélépipédique rectangle. Une pluralité de canaux parallèles (4) sont formés à travers le bloc (3) dans une direction orthogonale aux faces principales des couches, suivant une configuration de réseau de mailles à deux dimensions. Les canaux sont constitués en un matériau présentant une troisième constante diélectrique. Il s'agit préférentiellement de trous remplis d'air. On obtient ainsi la bande interdite photonique tridimensionnelle souhaitée dans une gamme de fréquences prédéterminée.

## Description

L'invention concerne une structure cristalline du type dit à bande interdite photonique tridimensionnelle. Elle concerne également un procédé de fabrication d'une telle structure.

Des découvertes récentes ont permis de mettre en évidence un phénomène physique particulier qui se développe au sein de structures diélectriques périodiques, tels certains cristaux présentant des différences de propriétés électriques périodiquement répétées à travers leur épaisseur. Ce phénomène a été qualifié de "bande interdite photonique", ou "PBG" (pour "Photonic Band Gap") selon la terminologie anglo-saxonne, par analogie à la bande interdite électronique que l'on peut créer dans des cristaux semi-conducteurs. Les structures à bande photonique de ce type seront appelées ci-après, par mesure de simplification, "cristaux photoniques".

A titre d'exemples non exhaustifs, de telles structures ont été décrites dans les articles ou livres suivants :
- le livre de J. D. JOANNOPOULOS et al., intitulé : "Photonic Crystals, Molding the Flow of Light", "Princeton University Press", 1995 ; et
- l'article : "Photonic Bandgap Materials", paru dans "Proceedings of the NATO advanced Institute on Photonic Bandgap Materials", ELOUNDA, Grèce, juin 1995.

Bien que des cristaux photoniques unidimensionnels aient été mis en oeuvre pour des couches d'adaptation depuis fort longtemps, l'idée de créer des structures à bande photonique interdite qui soient bi- ou tri- dimensionnelles ne date que d'une dizaine d'années. Depuis cette époque, et en raison des possibilités considérables qu'ils offrent, l'intérêt des cristaux photoniques a cru de façon très considérable. En effet, les cristaux photoniques sont susceptibles de nombreuses applications, et ils ont été effectivement mis en oeuvre dans des dispositifs tels que des lasers semi-conducteurs, des cellules solaires, des cavités résonnantes de haute qualité et des filtres.

Plus récemment, les cristaux photoniques ont trouvé application, du fait de leurs caractéristiques remarquables, dans la réalisation de circuits hyperfréquences, ou pour des composants fonctionnant dans des gammes d'ondes millimétriques ou sub-millimétriques. Plus particulièrement encore, ces cristaux ont trouvé une application avantageuse dans la réalisation d'antennes dites à bande interdite photonique, où ils servent de substrat au système d'antennes.

Dans ce type d'antennes, le cristal photonique sous-jacent interdit la propagation en son sein des ondes électromagnétiques à la fréquence considérée qui lui parviennent, en réfléchissant ainsi dans l'air environnant tout le rayonnement électromagnétique émanant du système qu'il supporte, pour autant que la fréquence de travail de l'antenne corresponde à celle de la bande interdite.

Il est donc effectivement possible de définir les cristaux photoniques comme étant les homologues électromagnétiques des cristaux semi-conducteurs considérés du point de vue de leur comportement vis-à-vis des électrons. Les cristaux photoniques possèdent une bande de fréquence pour laquelle les ondes électromagnétiques ne peuvent se propager à travers eux. Les particularités de fonctionnement des structures photoniques à bande interdite se trouvent dans la périodicité de la variation des propriétés diélectriques, dans le contraste diélectrique et dans l'arrangement structurel réalisé.

Les cristaux photoniques présentent des opportunités très importantes pour le futur, car ils permettent de réduire la masse globale du système où ils sont mis en oeuvre et ils améliorent les performances en termes d'efficacité de rayonnement qui sont essentielles pour des systèmes fonctionnant dans une gamme de radiofréquences ou une gamme de fréquences optiques d'étendue déterminée.

Les structures de cristaux à bande interdite photonique bidimensionnelle présentent l'avantage d'être faciles à fabriquer. Cependant, bien qu'elles puissent s'avérer utiles, les structures de cristaux à bande photonique tridimensionnelle semblent plus appropriées pour être utilisées comme substrats d'antenne. En effet, fondamentalement, une antenne rayonne dans un espace à trois dimensions. Il s'ensuit qu'il est préférable de prévoir une structure assurant une bande interdite photonique complètement tridimensionnelle, efficace à interdire la propagation du rayonnement électromagnétique à travers elle en couvrant toutes les directions du rayonnement dans l'espace, et capable de la sorte d'agir en réflecteur omnidirectionnel.

Quelques configurations tridimensionnelles ont été proposées dans l'art connu. On va en indiquer ci-après les exemples typiques et rappeler brièvement leurs principales caractéristiques en liaison avec leur procédé de fabrication.

Un premier type de structure de cristaux photoniques à bande interdite tridimensionnelle est décrit dans le brevet américain US-A-5 172 267 (déposé par Eli YABLONOVITCH), intitulé "Optical reflector structure, method of fabrication, and communication method".

La figure lA placée en fin de la présente description illustre les principales caractéristiques de la structure de cristal la ainsi que sa méthode de fabrication. Un masque 2, comportant un réseau de trous 2a, régulièrement répartis suivant une configuration à maille triangulaire, est disposé sur un bloc de cristal 10a, ayant la forme simple d'un barreau parallélépipédique rectangle. A travers ce masque, on réalise trois micro-usinages successifs ayant chacun pour effet de perforer le cristal en y ménageant des trous ou canaux rectilignes 100a selon des orientations déterminées différentes.

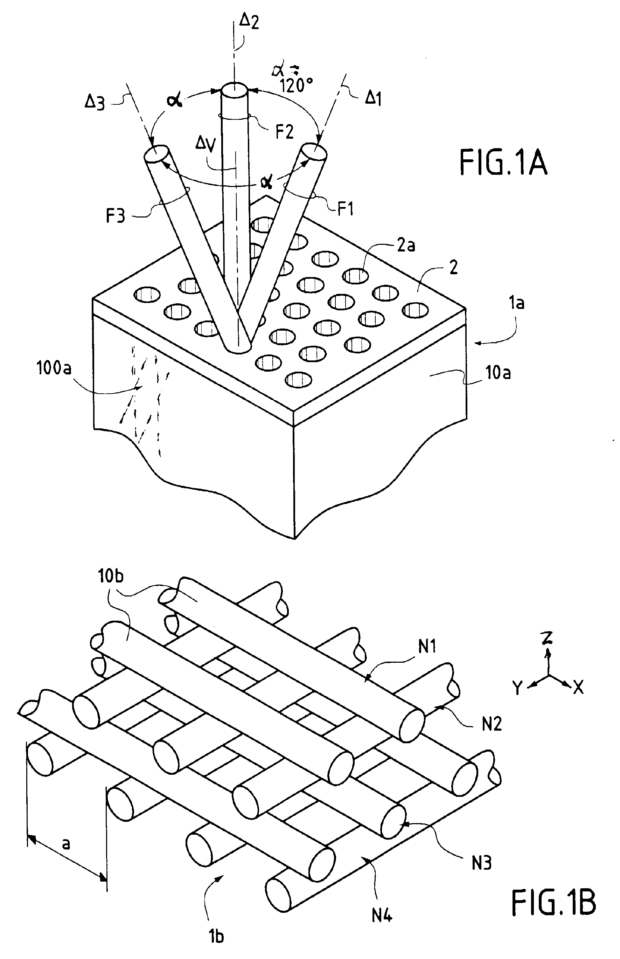

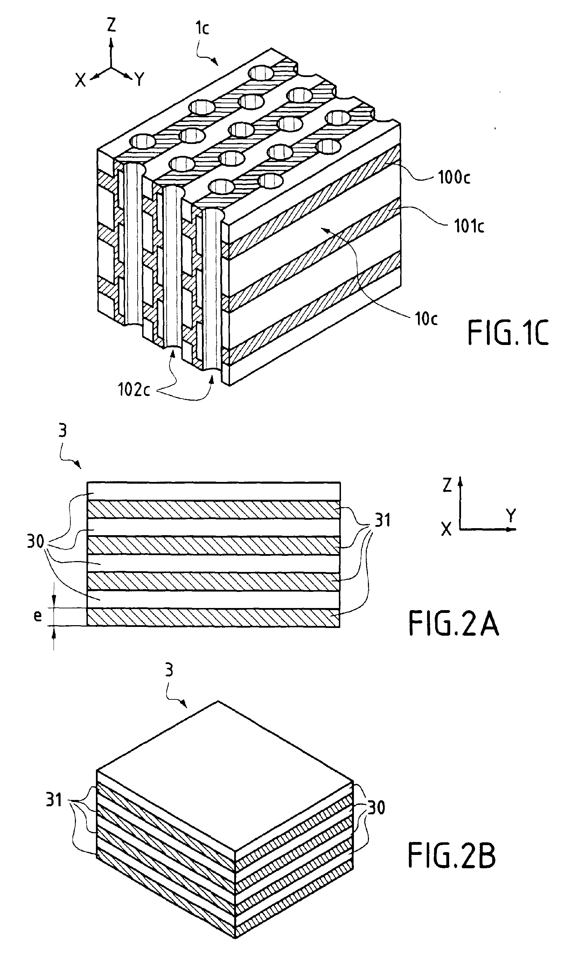

Les opérations de micro-usinage peuvent être effectuées, par exemple, en faisant appel à des techniques de perçage mécanique, de micro-lithographie ou d'attaque par faisceau d'ions, comme suggéré sur la figure 1A par la présence de trois faisceaux *f*1 à *f*3. De façon plus précise, les trois micro-usinages sont effectués respectivement selon trois directions différentes, Δ1 à Δ3, chacune formant un angle α d'amplitude identique prédéterminée avec un axe vertical Δ*V*, orthogonal à la face supérieure du masque 2, et donc du barreau 10a. L'angle α est précisément égal à 35,26 degrés. Les trois directions, Δ1 à Δ3, sont également réparties dans l'espace ; elles forment donc entre elles des angles de 120 degrés. Comme résultat de ces opérations de micro-usinage, on obtient un ensemble tridimensionnel de trous 100a constituant des canaux vides de matériau qui s'entrecroisent au sein du barreau 10a.

En choisissant de façon appropriée les caractéristiques physiques (constante diélectrique du matériau constituant le cristal de départ) et les caractéristiques géométriques (diamètre des trous du masque, distance entre trous adjacents), on obtient la structure à bande interdite photonique tridimensionnelle recherchée. Pour une description plus détaillée des caractéristiques de cette structure, on se reportera avec profit au texte du brevet américain US-A-5 172 267 précité.

Cependant, il est aisé de constater que le procédé de fabrication enseigné par ce document de brevet est très complexe, du fait notamment que l'on doit réaliser trois micro-usinages en opérant selon des directions différemment inclinées par rapport à l'axe vertical Δ*V*.

Un deuxième type de structures de cristaux photoniques, du type à bande photonique tridimensionnelle, est décrit dans le brevet américain US-A-5 406 573 (déposé par Ekmel OZBAY et al.). La configuration générale de la structure qui y est proposée, et décrite selon plusieurs variantes, peut s'apparenter à celle présentée par un tas de bois dans lequel s'empilent des couches de bûches orientées alternativement dans deux directions perpendiculaires d'une couche à l'autre.

La figure 1B placée en fin de la présente description, reprenant l'essentiel de la figure 2 du brevet précité, illustre une des variantes de structure décrites dans ce document, référencée 1*b* sur cette figure 1B. La structure 1*b* consiste en un empilement de tiges 10b, disposées en couches sur plusieurs niveaux, numérotées *N*1 à *N*4 sur la figure 1B, et de façon plus générale *N*l à *Nn*.

Toutes ces tiges sont disposées parallèlement à un plan de référence arbitraire, d'axes orthonormés *XY*, et elles sont parallèles entre elles dans une couche à un même niveau parallèle à ce plan. Les tiges relevant de deux niveaux successifs, par exemple *N*1 et *N*2, sont orthogonales entre elles, c'est-à-dire parallèles alternativement aux axes *X* et *Y* respectivement du référentiel *XY* quand on passe d'une couche à la suivante.

En outre, si on désigne par la valeur a le pas du réseau que représente la distance entre deux tiges adjacentes dans une même couche, les tiges 10*b*, toutes parallèles à l'un des axes *X* ou *Y*, appartenant les unes à un niveau de rang *n* (par exemple *N*4) et les autres à un niveau de rang *n*-2 (par exemple N2), sont décalées d'un demi pas, soit *a*/2. Les tiges de même orientation sont ainsi disposées en quinconce d'un niveau à l'autre, et ceci est valable pour chacune des deux orientations perpendiculaires. En d'autres termes, la séquence d'empilement se répète à l'identique toutes les quatre couches.

Comme précédemment, en choisissant de façon appropriée les caractéristiques physiques (constante diélectrique du matériau constitutif des tiges) et géométriques (diamètre des tiges et pas a, ce qui détermine un coefficient de remplissage représentatif du rapport entre le volume occupé par le matériau et le volume occupé par les zones vides subsistant entre les tiges), on obtient la structure à bande interdite photonique tridimensionnelle recherchée. Pour une description plus détaillée des caractéristiques de cette structure, on se reportera avec profit au brevet américain US-A-5 406 573 précité.

A priori, le procédé de fabrication de cette structure semble moins complexe que dans le cas précédent, dans la mesure où il consiste à disposer les couches de tiges successivement l'une par-dessus l'autre à la manière d'un tas de bois. Cependant, l'expérience montre que la structure ainsi réalisée est fragile et que le rendement obtenu faible.

Un troisième type de structure de cristaux photoniques est décrit dans le brevet américain US-A-5 600 483 (Shanhui FAN et al.). Un exemple d'une telle structure est illustré par la figure 1C, placée en fin de la présente description, qui reprend l'essentiel de la figure 1 du brevet précité.

La structure en trois dimensions lc est obtenue à partir d'une structure de base se présentant sous la forme d'un bloc de cristal parallélépipédique rectangle, dont les faces principales sont parallèles à un référentiel orthonormé arbitraire *XYZ*. Le bloc lc consiste en une pluralité de sous-structures en deux dimensions 10*c*, composées de strates formant des couches à des niveaux différents, décalées les unes par rapport aux autres, et parallèles au plan *XY* du référentiel *XYZ*. Les matériaux constituant ces strates présentent respectivement des première et deuxième constantes diélectriques : régions 100*c* et 101*c*, respectivement. La structure finale en trois dimensions est obtenue en réalisant des canaux 102c, en matériau d'une troisième constante diélectrique. Ces canaux 102c sont disposés parallèlement à l'axe *Z* du référentiel *XYZ*.

Comme dans les deux cas précédents, en choisissant de façon appropriée les caractéristiques physiques des matériaux utilisés (constantes diélectriques) et leurs caractéristiques géométriques (diamètre des canaux, entraxe d'un canal à l'autre, épaisseurs relatives des strates, etc.), on obtient la structure à bande interdite photonique recherchée. Pour une description plus détaillée des caractéristiques de cette structure, on se reportera avec profit au brevet américain US-A-5 600 483 précité.

Cependant cette structure reste complexe et elle nécessite de nombreuses étapes de fabrication.

L'invention vise à pallier les inconvénients des procédés et dispositifs de l'art connu, et dont certains viennent d'être rappelés. Elle vise notamment à simplifier la fabrication des cristaux photoniques fonctionnant dans les trois dimensions de l'espace, à réduire ainsi leur coût et à améliorer leurs performances, notamment pour les applications les faisant intervenir en tant que réflecteurs de rayonnement dans la fabrication d'antennes de télécommunication.

L'invention a en effet pour objet une structure diélectrique périodique du type dit à bande interdite photonique tridimensionnelle, de configuration simple, et combinant la facilité de fabrication des structures uni- ou bi-dimensionnelles et l'efficacité inhérente aux structures tridimensionnelles complètes.

Pour ce faire, la structure tridimensionnelle est obtenue à partir d'une structure de configuration très simple, essentiellement de nature unidimensionnelle, consistant en un empilement de strates ou couches de matériaux de constantes diélectriques différentes, *a priori* présentant deux constantes diélectriques alternativement. Cette structure de base est obtenue par divers procédés de fabrication, bien connus en soi, tels que des techniques de dépôt ou de collage. Un réseau de canaux répartis suivant une distribution périodique en deux dimensions est ensuite réalisé à travers la structure à périodicité unidimensionnelle. Les canaux sont percés perpendiculairement aux faces principales des couches de la structure de base en respectant une configuration de trame à mailles régulières, par exemple carrées, rectangulaires, ou triangulaires.

Par ces dispositions propres à l'invention, on obtient une structure diélectrique périodique du type dit à bande interdite photonique tridimensionnelle qui, tout en étant capable de performances correspondant au moins à celles des structures tridimensionnelles complètes qui ont été décrites, ont l'intérêt de ne pas présenter leur complexité et de ne pas impliquer de difficultés particulières de fabrication.

Pour cela il convient que le milieu interne aux canaux présente un indice de réfraction représentatif d'une troisième constante diélectrique, différente de celles respectives des couches d'ordre pair et d'ordre impair de l'empilement. Les canaux peuvent être remplis d'un matériau approprié, notamment à base de résines organiques et durci sur place. Toutefois, selon un mode de réalisation préféré de l'invention, bien adapté en particulier pour des applications en antennes fonctionnant dans l'atmosphère, les canaux sont laissés vides, et donc finalement constitués par des trous remplis d'air. Il s'ensuit que la constante diélectrique y est égale à l'unité, ce qui permet d'obtenir un fort contraste diélectrique avec les autres matériaux de la structure.

L'invention a donc pour objet principal une structure cristalline du type dit à bande interdite photonique tridimensionnelle, caractérisée en ce qu'elle comprend un empilement périodique de deux séries de couches alternées réalisées en des matériaux diélectriques distincts, lesdits matériaux étant associés à des première et deuxième constantes diélectriques différentes déterminées, chacune desdites couches de matériaux étant de préférence plane en forme de parallélépipède rectangle d'épaisseur déterminée et ledit empilement formant un bloc sensiblement parallélépipédique rectangle, et une pluralité de canaux parallèles formés au sein dudit bloc à travers lesdites couches suivant une direction orthogonale à leurs faces principales, lesdits canaux étant répartis de manière à former un réseau de mailles suivant une trame en deux dimensions et présentant une troisième constante diélectrique déterminée.

L'invention a aussi pour objet un procédé de fabrication d'une telle structure impliquant le percement desdits canaux à répartition périodique bi-dimensionnelle à travers ledit empilement de couches à périodicité uni-dimensionnelle préalablement réalisé, ainsi que leur remplissage éventuel.

En sélectionnant de manière appropriée la nature des matériaux utilisés et les valeurs que l'on donne ainsi aux constantes diélectriques, l'épaisseur des couches de l'empilement, le type de maille et le pas du réseau de canaux ainsi que la section de ces canaux, ou d'une manière générales les propriétés physiques des différents constituants de la structure et les dimensions géométriques caractérisant les couches et les canaux, de façon à obtenir la bande interdite photonique tridimensionnelle désirée, dans une gamme de fréquences prédéterminée.

L'invention va maintenant être décrite de façon plus détaillée en se référant aux dessins annexés, parmi lesquels :
- les figures 1A à 1C illustrent schématiquement trois exemples de structures cristallines du type dit à bande interdite photonique tridimensionnelle selon l'art connu ;
- les figures 2A et 2B illustrent schématiquement la première étape de fabrication d'une structure cristalline du type dit à bande interdite photonique tridimensionnelle selon l'invention, en vue de côté et en perspective, respectivement ;
- les figures 3A et 3B illustrent schématiquement la deuxième étape de fabrication de cette même structure, respectivement en vue de côté et en perspective avec une coupe partielle ;
- la figure 3C est une vue de détail montrant une configuration particulière de la structure des figures 3A et 3B ;
- et la figure 4 est une courbe mettant en évidence la bande interdite photonique précitée.

Les figures lA à 1C ont déjà été décrites. Il n'est pas besoin d'y revenir.

Un exemple d'une structure cristalline périodique du type dit à bande interdite photonique tridimensionnelle constituée et réalisée conformément à l'invention va maintenant être détaillé par référence aux figures 2A à 4.

Comme il a été indiqué, la structure tridimensionnelle finale est obtenue à partir d'une structure de base présentant une configuration essentiellement de nature uni-dimensionnelle. Cette structure de base est réalisée lors d'une première étape du procédé de fabrication, illustrée plus particulièrement par les figures 2A et 2B, où la structure est montrée en coupe et en vue en perspective respectivement.

A l'issue de cette première étape, on obtient un bloc parallélépipédique rectangle 3, caractérisé par une variation périodique de l'indice de réfraction, donc des propriétés diélectriques, suivant une direction parallèle à l'une de ses dimensions. Ce bloc 3 est en effet constitué d'un empilement de strates, sous la forme de couches planes et d'épaisseur constante, référencées 30 et 31. Ces couches, toutes de la même épaisseur *e*, sont constituées en des matériaux distincts, présentant des constantes diélectriques différentes.

Plus précisément, on utilise deux matériaux de constantes diélectriques différentes, alternativement d'une couche à la suivante. Chacune des couches alternées, 30 ou 31, est donc de forme substantiellement parallélépipédique rectangle comme l'empilement et, de façon arbitraire, on suppose que leurs faces principales sont orientées parallèlement au plan *XY* d'un trièdre de référence orthonormé *XYZ*.

Le nombre de couches est déterminé en fonction de l'atténuation minimale désirée,laquelle est en liaison avec la périodicité, conformément à ce qui a été amplement décrit, par exemple, par S.Y Lin and G. Arvalingham (Tunnelling of electromagnetic waves in two-dimensional photonic crystals, Optics Letters, vol 18, nol9, October 1 1993, p1666-1668) qui ont donné compte-rendu de mesures de l'atténuation en fonction du nombre de couches. Il correspond typiquement, dans la structure spécifiquement considérée ici en exemple, à cinq périodes, ce qui implique qu'il y ait dix couches superposées dans la structure.

Les matériaux composant les couches 30 et 31, appartenant respectivement aux deux séries d'ordre pair et d'ordre impair, sont choisis de manière à obtenir un bon contraste diélectrique entre chaque couche et les deux couches adjacentes qui l'encadrent.

L'invention reste compatible avec les technologies du domaine de l'application préférée considérée, à savoir la réalisation de substrats d'antenne. Pour fixer les idées, on peut choisir, en alternance, du silicium et du dioxyde de silicium SiO₂, ou encore de l'arséniure de gallium GaAs et de l'arséniure de gallium aluminium de formule générale Al_{*x*}Ga₁₋_{*x*}As.

De même, pour la réalisation de la structure de base 3, on peut faire appel à des techniques de fabrication bien connues en soi : dépôt par croissance épitaxiale, couche de matériau par couche de matériau, collage de couches, etc. Ces méthodes étant très utilisées et bien maîtrisées, dans le domaine considéré ou dans des domaines connexes (réalisation de circuits intégrés, etc.), elles permettent des coûts de fabrication peu élevés et un bon rendement.

Lors d'une seconde étape, pour compléter la structure de base constituée par le bloc 3, on réalise à travers lui un réseau de canaux tous orientés suivant une direction perpendiculaire aux faces principales des couches 30 - 31 de l'empilement, c'est-à-dire parallèlement à l'axe *Z* du trièdre de référence orthonormé *XYZ*.

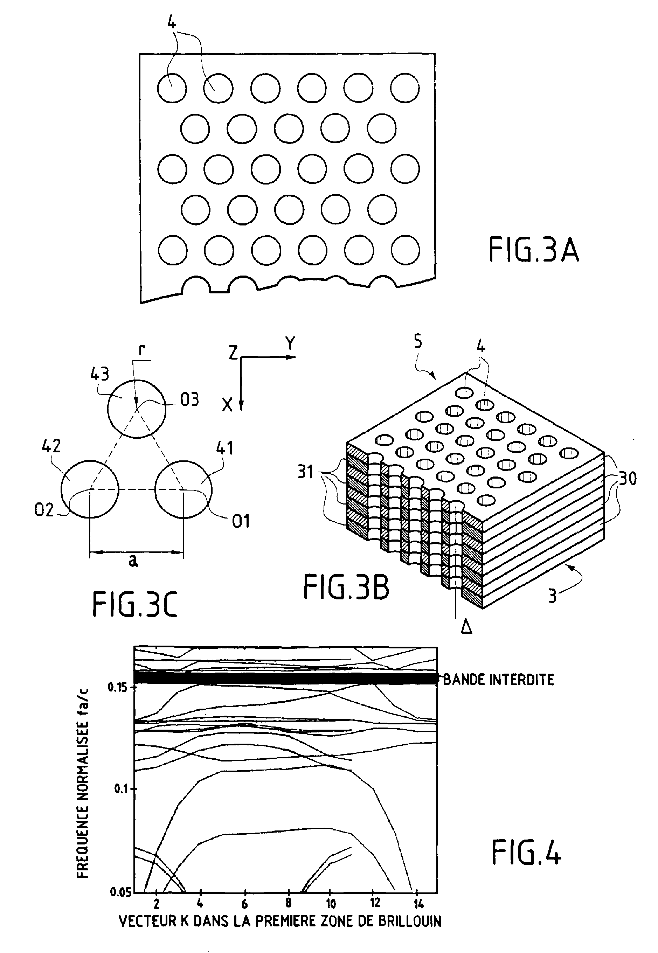

Cette étape va être décrite par référence aux figures 3A et 3B, représentant la structure complète finale 5, en vue de dessus et en perspective, avec une coupe partielle, pour mieux mettre en évidence les caractéristiques de la structure selon l'invention.

Les canaux, référencés 4, y sont représentés sous la forme de trous cylindriques, donc de section circulaire chacun autour d'un axe de symétrie Δ (figure 3B), rectiligne parallèlement à l'axe *Z*. Ils sont régulièrement répartis dans le volume du bloc 3 suivant un réseau respectant une trame de mailles se répétant périodiquement dans deux directions.

De façon préférentielle, les canaux 4 sont constitués de trous traversant le bloc 3 de part en part, qui sont ensuite laissés vides, de façon à ce qu'ils soient remplis d'air, de constante diélectrique égale à l'unité. Cette disposition permet d'avoir un grand contraste diélectrique avec les matériaux respectifs des couches alternées dans l'empilement périodique de base.

Une fois cette étape terminée, on obtient une structure cristalline 5 qui constitue un cristal photonique opposant une barrière interdite tridimensionnelle à la transmission du rayonnement électromagnétique, en liaison avec la répartition périodique des propriétés diélectriques qu'elle présente dans les trois dimensions de l'espace.

Suivant la longueur d'onde de travail du dispositif utilisant cette structure (ondes radiofréquences, dans la gamme des hyperfréquences, ou ondes optiques), on pourra faire appel à diverses technologies pour réaliser les trous destinés à constituer les canaux 4 (avec ou sans remplissage par un matériau spécifique tel qu'une matière à base de résines organiques durcissables) : simple perçage, photolithographie, attaque par faisceau d'ions actifs, micro-usinage, etc. De nouveau, ces techniques sont bien connues en soi, d'utilisation courante, et elles sont bien maîtrisées. De façon avantageuse en liaison avec ce genre de technologie, mais bien que cela ne constitue pas une obligation, les trous sont dotés d'une section circulaire comme il a été représenté sur les figures et indiqué précédemment.

Dans le réseau à variation périodique bi-dimensionnelle considéré dans un plan parallèle au plan *XY*, la configuration d'implantation des trous ou canaux 4 peut prendre diverses formes : carrée, triangulaire, hexagonale, etc.

A titre d'exemple, la figure 3C est une figure de détail illustrant schématiquement une maille du réseau dans une implantation triangulaire des trous. On a représenté trois trous, en vue de dessus, référencés 41 à 43, de centres *O*1 à *O*3, et de rayon r. Les centres, *O*1 à *O*3, sont disposés aux sommets d'un triangle équilatéral et sont éloignés les uns des autres d'un pas a, cette configuration se répétant périodiquement dans le plan *XY*. D'une rangée à l'autre, les trous matérialisant les canaux à répartition bi-dimensionnelle se disposent donc en quinconce avec un décalage d'un demi-pas entre deux rangées successives.

On constate aisément que la structure conforme à l'invention, telle qu'elle vient d'être décrite à titre d'exemple, présente plusieurs degrés de liberté, qui pourront être utilisés pour optimiser la largeur de la bande interdite et ses qualités tridimensionnelles, en fonction de la configuration de l'implantation des trous ou canaux, notamment par rapport à celle de l'empilement de couches dans le bloc global, ou en fonction des matériaux constituant les couches de l'empilement de base et du milieu remplissant les canaux ménagés à travers ces couches, qu'il s'agisse d'air ou d'un autre matériau.

On peut constater également que la structure qui vient d'être décrite est par nature très robuste et que le procédé de fabrication est très simple. La solidité mécanique de l'ensemble vient notamment du fait que l'on perce des trous à travers un bloc matériel, ce qui, même si les trous ainsi formés restent vides et donc seulement remplis d'air dans le cadre des applications de la structure, conduit à un coefficient de vide relativement faible par rapport aux structures de l'art antérieur utilisant des empilements de tiges pleines.

Pour fixer les idées, on va maintenant donner les particularités d'un exemple pratique de réalisation correspondant aux conditions de mise en oeuvre préférées de l'invention dans son application à la réalisation d'antennes dans le domaine des télécommunications atmosphériques.

Le bloc cristallin 3 comprend deux séries de couches alternées, qui sont réalisées en des matériaux différant entre eux par l'indice de réfraction, et donc par la constante diélectrique. Dans l'exemple, les matériaux sont tels que pour les couches d'ordre pair et pour les couches d'ordre impair respectivement, les constantes diélectriques soient égales à ε_{*r*}₁ = 11,8 et ε_{*r*}₂ = 250. Le contraste diélectrique entre couches adjacentes est avantageusement choisi très élevé afin d'améliorer les performances de la structure critalline obtenue. Pour le troisième matériau, la constante diélectrique est égale à l'unité, la matière interne aux canaux percés à travers les couches étant en fait de l'air.

Les dimensions du bloc 3 sont adaptées, dans les trois directions de l'espace, pour assurer un pas de répétition périodique correspondant à celui qui demande la fréquence de travail. D'autre part, le nombre de couches de même ordre dans la direction Z, sur la hauteur de l'empilement, étant de cinq comme déjà indiqué, on rencontre sensiblement le même nombre de trous formant les canaux 4 dans les directions de la longueur du bloc et de sa largeur.

Si l'on désigne par a le pas, l'épaisseur de chaque couche sera égale à *a*/2. On admet ici que les couches d'ordre pair et d'ordre impair présentent la même épaisseur, mais ceci n'est nullement indispensable. A titre d'exemple, pour obtenir une bande interdite photonique autour d'une fréquence *f* de 500 GHz, le pas est fixé à 96 micromètres, puisque l'on a *f a* / *c* = o,16, *c* étant la célérité de la lumière.

Quant aux canaux, ils sont répartis de manière à assurer sensiblement la même périodicité des variations de la constante diélectrique. Le pas a désigne donc également la distance entre les axes de deux trous adjacents. En exemple, l'implantation des trous présente une configuration hexagonale à mailles triangulaires, telle qu'illustrée par la figure 3C. Le rapport entre le rayon r des trous cylindriques et le pas a (ou largeur de maille) du réseau (voir figure 3C) est égal à *r/a* = 0,4. Ce rapport peut varier, par exemple, de 0,4 à 0,5. Il témoigne du coefficient de remplissage de la structure, correspondant au rapport entre le volume occupé dans le bloc de la structure par les canaux restant vides et le volume total, y compris les parties subsistant solides du bloc initial.

Le cristal constitué comme ci-dessus est utilisé comme support d'antenne. L'antenne repose sur le dessus de ce cristal par l'intermédiaire d'une fine couche transparente facilitant les modifications de disposition et d'orientation. Il est à noter que la présence de creux sur les bords du bloc (figures 3A et 3B) n'a pas d'incidence sensible dès lors que le nombre de périodes est suffisant.

Globalement on parvient ainsi à des performances photoniques tridimensionnelles dont la qualité est sensiblement la même que ce que l'on peut obtenir avec les techniques antérieures à l'invention, bien que la géométrie de la configuration en réseau ne soit pas homogène dans les trois dimensions du cristal compte tenu des différences dans la répétition périodique des contrastes de propriétés diélectriques.

Un cristal tel que ci-dessus a été soumis à différents essais. On a notamment déterminé le spectre en ondes planes se propageant dans différentes directions.

La figure 4 est un diagramme représentant l'évolution des fréquences normalisées exprimées en valeurs de *f a / c* en fonction de la valeur (en radians) du vecteur K de la direction de propagation, dans la première zone de Brillouin. Ce spectre fait ressortir la bande photonique à la valeur 0,16 en ordonnée.

La largeur de bande totale est de 3%. Une optimisation peut être obtenue en ajustant le rapport *r/a* précité, les valeurs des constantes diélectriques ou le nombre de couches de l'empilement.

A la lecture de ce qui précède, on constate aisément que l'invention atteint bien les buts qu'elle s'est fixés. Il doit être clair cependant qu'elle n'est pas limitée aux seuls exemples de réalisation qui viennent d'être explicitement décrits, notamment en relation avec les figures 2A à 4.

En particulier, les valeurs numériques n'ont été précisées que pour fixer les idées. Elles dépendent essentiellement de l'application précise visée, notamment de la fréquence de travail du dispositif utilisant la structure cristalline à bande interdite photonique.

Il doit être clair aussi que, bien qu'elle soit particulièrement adaptée à la réalisation de substrats d'antenne, on ne saurait cantonner l'invention à ce seul type d'application.

De même, pour d'autres applications, on pourra préférer combler les trous percés à travers l'empilement de couches avec une matière solide intégrée dans l'ensemble plutôt que de la laisser se remplir par le milieu environnant, notamment par l'air atmosphérique.

## Revendications

1. Structure cristalline du type dit à bande interdite photonique tridimensionnelle, caractérisée en ce qu'elle comprend un empilement d'au moins deux séries alternées de couches de matériaux diélectriques distincts respectivement associés à des première et deuxième constantes diélectriques déterminées, lesdites couches (30, 31) présentant une épaisseur constante déterminée et ledit empilement formant un bloc (3) sensiblement parallélépipédique rectangle, et une pluralité de canaux parallèles (4) formés au sein dudit bloc (3) et le traversant suivant une direction (*Z*) orthogonale aux dites faces principales, lesdits canaux étant répartis suivant une trame de réseau à deux dimensions et présentant une troisième constante diélectrique déterminée, lesdites constantes diélectriques, les dimensions géométriques relatives caractérisant lesdites couches (30, 31) et lesdits canaux (4) étant sélectionnés de façon à obtenir ladite bande interdite photonique tridimensionnelle dans une gamme de fréquences prédéterminée.

2. Structure cristalline selon la revendication 1, caractérisée en ce que lesdits canaux parallèles sont constitués de trous (4) de section circulaire, tous de même diamètre, lesdits trous (4) étant remplis d'air.

3. Structure cristalline selon la revendication 1 ou 2, caractérisée en ce que la configuration d'implantation desdits canaux (41-43) dans un plan (*XY*) parallèle auxdites faces principales est à maille triangulaire.

4. Structure cristalline selon l'une quelconque des revendications précédentes, caractérisée en ce que lesdites première, deuxième et troisième constantes diélectriques ont des valeurs très différentes les unes des autres, de manière à obtenir un contraste diélectrique élevé.

5. Structure cristalline selon l'une quelconque des revendications 1 à 4, caractérisée en ce que ladite gamme de fréquences prédéterminée est comprise dans la gamme des hyperfréquences ou celle des ondes optiques.

6. Structure cristalline selon l'une quelconque des revendications 1 à 5, caractérisée en ce qu'elle est destinée à constituer un substrat d'antenne.

7. Procédé de fabrication d'une structure cristalline du type dit à bande interdite photonique tridimensionnelle selon l'une quelconque des revendications précédentes, caractérisé en ce qu'il comprend les étapes suivantes :
- une première étape consistant en la réalisation d'un empilement de couches alternées de deux matériaux distincts (30, 31), chacune desdites couches de matériaux formant sensiblement un parallélépipède rectangle d'épaisseur déterminée et ledit empilement formant ledit bloc sensiblement parallélépipèdique rectangle (3), lesdits matériaux étant associés aux dites première et deuxième constantes diélectriques déterminées ; et
- une deuxième étape consistant en la réalisation d'une pluralité de canaux (4) au sein dudit bloc, suivant une direction orthogonale aux faces principales desdites couches alternées (30, 31) .

8. Procédé selon la revendication 7, caractérisé en ce que ledit empilement (3) de couches alternées (30, 31) réalisé pendant ladite première étape est obtenue par croissance épitaxiale de deux séries de couches de matériaux distincts.

9. Procédé selon la revendication 7, caractérisé en ce que ledit empilement (3) de couches alternées (30, 31) réalisé pendant ladite première étape est obtenue par collage de deux séries de couches de matériaux distincts.

10. Procédé selon l'une quelconque des revendications 7 à 9, caractérisé en ce que pour constituer lesdits canaux, on perce des trous (4) régulièrement répartis suivant ledit réseau à travers ledit bloc (3) suivant une direction (*Z*) orthogonale aux faces principales desdites couches alternées (30, 31).
